(19) Europäisches Patentamt / European Patent Office / Office européen des brevets

(11) **EP 2 524 236 B1**

(12) **FASCICULE DE BREVET EUROPEEN**

(45) Date de publication et mention de la délivrance du brevet:
**06.08.2014 Bulletin 2014/32**

(21) Numéro de dépôt: **11704262.2**

(22) Date de dépôt: **07.01.2011**

(51) Int Cl.:
**G01R 33/00** (2006.01)

(86) Numéro de dépôt international:
**PCT/FR2011/050024**

(87) Numéro de publication internationale:
**WO 2011/083279 (14.07.2011 Gazette 2011/28)**

(54) **PROCÉDÉ AMÉLIORÉ DE DÉTERMINATION DE L'AIMANTATION DE LA COQUE D'UN NAVIRE ET DISPOSITIF ASSOCIÉ**

VERBESSERTES VERFAHREN ZUR BESTIMMUNG DER MAGNETISIERUNG DER HÜLLE EINES SCHIFFS UND ENTSPRECHENDE VORRICHTUNG

IMPROVED METHOD FOR DETERMINING THE MAGNETISATION OF THE HULL OF A SHIP, AND ASSOCIATED DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.01.2010 FR 1050138**

(43) Date de publication de la demande:
**21.11.2012 Bulletin 2012/47**

(73) Titulaire: **DCNS**
**75015 Paris (FR)**

(72) Inventeurs:
• **DEMILIER, Laurent**
**F-29470 Plougastel Daoulas (FR)**
• **VUILLERMET, Yannick**
**F-73000 Chambéry (FR)**
• **CHADEBEC, Olivier, Nicolas**
**F-38100 Grenoble (FR)**
• **COULOMB, Jean-Louis**
**F-38330 Saint-Ismier (FR)**
• **ROUVE, Laure-Line**
**F-38570 Theys (FR)**
• **CAUFFET, Gilles**
**F-38210 Saint Quentin sur Isère (FR)**

(74) Mandataire: **Blot, Philippe Robert Emile**
**Cabinet Lavoix**
**2, place d'Estienne d'Orves**
**75441 Paris Cedex 09 (FR)**

(56) Documents cités:
**FR-A1- 2 825 803       US-A1- 2005 030 021**
**US-A1- 2006 282 492**

EP 2 524 236 B1

**Description**

L'invention a pour domaine technique celui des procédés de régulation de la signature magnétique d'un navire.

La signature d'un navire est l'ensemble des valeurs du champ magnétique crée par le navire, évaluées dans un plan de référence. Lorsqu'il s'agit d'un navire de surface, ce plan de référence est généralement horizontal, situé sous la coque du navire environ à environ une fois la largeur du navire, soit typiquement 10 à 30 m.

FR 2 825 803 divulgue un procédé de régulation de la signature magnétique d'un navire.

Dans sa partie de détermination de la signature du navire, ce procédé prévoit l'acquisition d'une pluralité de mesures du champ magnétique, au moyen d'une pluralité de capteurs situés à l'intérieur de la coque du navire.

Puis, à partir de cette pluralité de mesures et de la valeur du champ magnétique terrestre local, il prévoit de calculer la distribution d'aimantation la plus probable à la surface de la coque en utilisant une première modélisation qui associe une distribution d'aimantation à une pluralité de mesures du champ magnétique, et une seconde modélisation qui couple l'aimantation en un point de la coque avec l'aimantation en un autre point de la coque.

L'aimantation dont il est question est l'aimantation totale en un point de la coque, correspondant à l'addition de l'aimantation permanente et de l'aimantation induite en ce point.

Enfin, la distribution d'aimantation ainsi calculée est utilisée pour estimer la valeur du champ magnétique crée par la coque dans le plan de référence, c'est-à-dire la signature du navire.

Dans sa partie de régulation, ce procédé prévoit de minimiser la signature du navire ainsi déterminée. Pour cela, la coque du navire est équipée de plusieurs boucles dites « d'immunisation magnétique », réalisées en un matériau conducteur du courant électrique, et le navire embarque des moyens de puissance électrique permettant de faire circuler des courants électriques adaptés dans chacune des boucles indépendamment. La circulation d'un courant dans une boucle génère un champ magnétique qui se superpose au champ magnétique terrestre local et au champ créé par la distribution d'aimantation sur la coque, sachant que cette dernière est modifiée par le champ magnétique généré par les boucles. Ainsi, en régulant les courants électriques circulant dans les différentes boucles, la signature du navire est minimisée.

La précision de ce procédé repose sur la représentativité de la pluralité de mesures du champ magnétique au moyen de la pluralité de capteurs situés à l'intérieur de la coque et sur l'aptitude des première et seconde modélisations à déterminer avec précision l'aimantation de la coque à partir des mesures issues des capteurs.

Lorsque les capteurs sont situés à l'intérieur de la coque, loin de celle-ci, le procédé permet de déterminer de façon satisfaisante l'aimantation de la coque correspondant aux mesures effectuées.

Or, la mesure, dans l'air, du champ magnétique crée par la coque est perturbée. En effet, un navire renferme des sources magnétiques secondaires, telles que les masses ferromagnétiques que constituent ses moteurs. Ces sources magnétiques secondaires produisent des champs magnétiques secondaires qui se superposent au champ magnétique crée par la coque. Les champs magnétiques secondaires constituent une forte perturbation pour l'information que l'on cherche à obtenir au moyen des capteurs. Aussi, les mesures ne sont pas bien représentatives du champ magnétique résultant de l'aimantation de la coque. De ce fait, l'aimantation de la coque calculée à partir des mesures faites à l'intérieur du navire n'est pas représentative, avec précision, de l'aimantation réelle de la coque. Il en résulte que la signature du navire calculée ainsi peut être très différente de la signature réelle du navire.

Pour améliorer le rapport signal pertinent sur perturbation, il a été envisagé de rapprocher les capteurs de la coque, pour les disposer à proximité immédiate de celle-ci et les éloigner, autant que possible, des sources magnétiques secondaires.

Mais, lorsque l'on rapproche les capteurs de la coque, la signature déterminée par la mise en oeuvre du procédé décrit dans le document FR 2 825 803 ne correspond plus à la signature réelle du navire.

L'invention a donc pour but de pallier ce problème en proposant un procédé de détermination de l'aimantation de la coque d'un navire permettant d'obtenir, à partir de mesures de champ magnétique faites à l'aide de capteurs embarqués par le navire, une solution qui soit robuste et qui ne soit pas perturbée par des sources de champ magnétique parasite contenues dans la coque du navire.

L'invention a donc pour objet un procédé de détermination, en temps réel, de l'aimantation de la coque d'un navire, un procédé de détermination, en temps réel, de la signature magnétique d'un navire, un procédé d'immunisation magnétique d'un navire, un dispositif de détermination, en temps réel, de l'aimantation de la coque d'un navire et un dispositif d'immunisation magnétique d'un navire selon les revendications.

Les dispositifs précédents sont avantageusement embarqués à bord du navire dont on détermine l'aimantation de la coque.

L'invention et ses avantages seront mieux compris à la lecture de la description qui va suivre, donnée uniquement à titre d'exemple, et faite en se référant aux dessins annexés, sur lesquels :

- la figure 1 est une représentation schématique de l'installation permettant de réguler la signature d'un navire ;
- la figure 2 est une représentation d'une portion du maillage de la coque et de son maillage dual ;

- la figure 3 est une représentation sous forme d'un organigramme du procédé de régulation ; et,
- les figures 4 et 5 sont des graphes donnant la valeur de la signature pour différentes positions longitudinales sous la coque du navire.

Dispositif

Le navire dont on cherche à réguler la signature magnétique comporte une coque 1 qui est réalisée par assemblage de tôles. Les tôles utilisées sont en un matériau ferromagnétique caractérisé par une susceptibilité magnétique réversible $\chi$.

La coque présente une surface intérieure 3, orientée vers l'intérieur du navire, et une surface extérieure 5, orientée vers l'extérieur du navire.

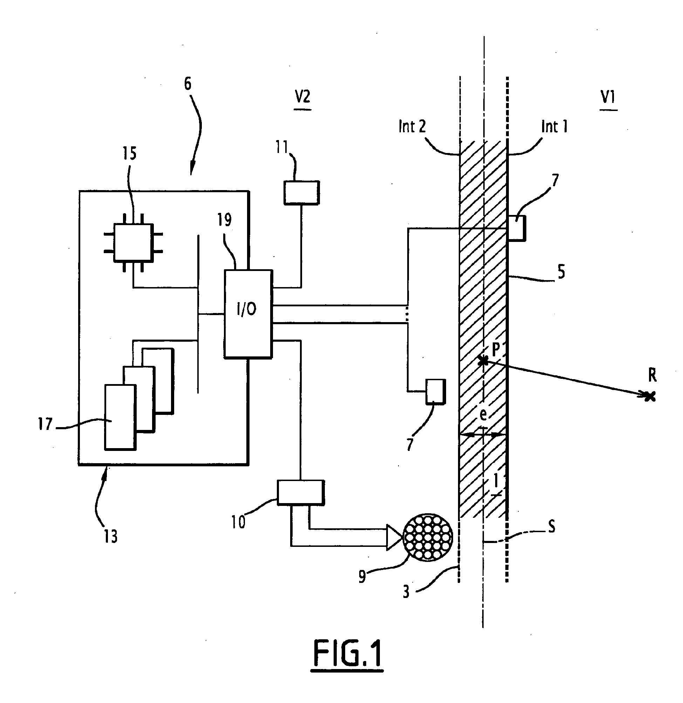

Le navire embarque un dispositif, indiqué par la référence générale 6 sur la figure 1, de détermination, en temps réel, de l'aimantation de la coque d'un navire. Le dispositif 6 est propre à mettre en oeuvre les procédés de détermination de l'aimantation de la coque d'un navire, et détermination de la signature du navire et d'immunisation magnétique du navire.

Le dispositif 6 comporte une pluralité de capteurs du champ magnétique 7. Par exemple, 50 capteurs sont disposés dans le volume V2 délimité intérieurement par la surface intérieure 3 de la coque 1. Les capteurs 7 sont placés à proximité de la surface intérieure 3 et, de préférence, collés sur cette surface. D'un point de vue pratique, il s'agit d'un mélange entre capteurs bi-axes et tri-axes. Dans le cas présent, les capteurs 7 étant collés à la coque ou, tout au moins, très proches de celle-ci, seules les mesures des composantes de l'induction magnétique $B$ tangentes à la coque sont prises en compte. En effet, la mesure de la composante normale de l'induction magnétique $B$ présente un rapport signal sur bruit défavorable et l'inclure dans les modélisations peut se révéler catastrophique en termes de convergence vers une solution robuste, c'est-à-dire stable par rapport aux incertitudes de mesure. L'information ajoutée par cette composante normale étant peu représentative, il n'en est pas tenu compte dans le procédé selon l'invention. La position de chaque capteur 7 par rapport à la coque est connue.

Le dispositif 6 comporte également une pluralité de boucles d'immunisation 9 de circulation d'un courant électrique. Les boucles 9 sont réalisées en un matériau conducteur du courant électrique. Les boucles 9 sont indépendantes les unes des autres. Elles forment des circuits électriques de géométrie et de positionnement connus par rapport à la coque.

Le dispositif 6 comporte des moyens d'alimentation en puissance électrique 10 aptes à être commandés de manière à faire circuler des courants adaptés dans chacune des boucles 9 indépendamment les unes des autres.

La circulation d'un courant dans une boucle 9 génère une excitation magnétique $H$ propre à induire une distribution d'aimantation dans la coque 1. Ainsi, les différentes boucles 9 permettent de modifier la valeur de l'excitation magnétique inductrice $H_0$.

Le dispositif 6 comporte un moyen 11 d'évaluation de l'excitation magnétique inductrice $H_0$. Il s'agit par exemple d'un moyen permettant d'évaluer, à l'instant considéré, à la fois l'excitation magnétique terrestre à l'endroit où se situe le navire, et l'excitation magnétique induite par les boucles d'immunisation en chaque point de la coque du navire.

Le dispositif 6 comporte une unité de calcul 13 apte à mettre en oeuvre les différentes étapes des procédés de détermination de l'aimantation de la coque, de détermination de la signature du navire, et d'immunisation, décrits en détail ci-après.

De préférence, l'unité 13 comprend un processeur 15 et une unité de mémorisation 17, telle qu'une mémoire morte et une mémoire vive. Elle comprend également une interface entrée/sortie 19 à laquelle sont connectés les capteurs 7, le moyen 11, ainsi que les moyens d'alimentation en puissance électrique 10.

A chaque pas de temps, l'unité de calcul 13 exécute un programme informatique dont les instructions sont mémorisées dans l'unité de mémorisation 17.

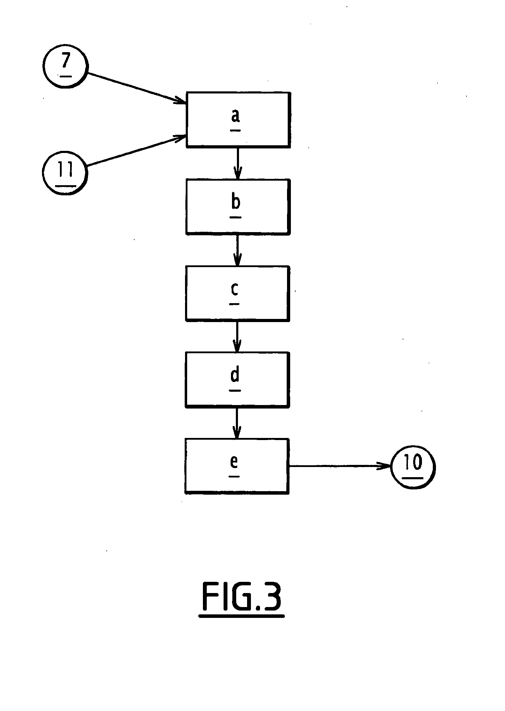

L'exécution de ce programme met en oeuvre les différentes étapes du procédé d'immunisation magnétique du navire, représenté de manière schématique sur la Figure 3. Ce procédé comporte les étapes consistant à :

a) - acquérir une pluralité de mesures du champ magnétique au moyen de la pluralité de capteurs ;

b) - évaluer l'excitation magnétique inductrice ;

c) - déterminer, en résolvant un système d'équations résultant de la modélisation des phénomènes physiques mis en jeu, à partir de la pluralité de mesures acquises et de l'excitation magnétique inductrice évaluée, une distribution de sources magnétiques probable à la surface de la coque,

d) - calculer la signature du navire à partir de la distribution de sources magnétiques probable ; et,

e) - commander les moyens d'alimentation en puissance électrique de manière à faire circuler des courants adaptés dans les boucles, pour modifier l'excitation magnétique des inducteurs et, par conséquent, réguler la signature du navire.

L'étape c) met en oeuvre une modélisation des phénomènes physiques, un modèle virtuel de la coque du navire pour discrétiser cette modélisation et obtenir un système d'équations à résoudre, et des méthodes mathématiques de résolution de ces équations. Ces éléments vont d'abord être présentés.

Généralités

La signature magnétique du navire est donnée par l'ensemble des valeurs de l'induction magnétique en différents points d'une surface de référence. Pour un navire de surface, cette surface de référence est une portion d'un plan situé sous la coque, à par exemple environ 10 mètres. Pour un sous-marin, cette surface de référence est une portion d'un cylindre coaxial et extérieur à la coque sensiblement cylindrique.

L'induction magnétique sur cette surface de référence résulte de la superposition, d'une part, de l'induction magnétique terrestre et de l'induction magnétique créée par les boucles de courant équipant le navire et, d'autre part, par l'induction magnétique créée par l'aimantation $M$ portée par la coque.

L'aimantation $M(P)$ en un point $P$ de la coque ferromagnétique comprend une composante induite $M^{ind}$, proportionnelle à l'excitation magnétique totale $H(P)$ au point $P$ $(M^{ind} = \chi H)$, et une composante rémanente $M^{rem}$, résultant de l'histoire magnétique de la coque.

L'excitation magnétique totale $H(P)$ en un point $P$ de la coque ferromagnétique comprend une composante $H_0$, dite inductrice, indépendante du matériau, provenant de l'excitation magnétique terrestre et de l'excitation magnétique crée par les différentes boucles de courant, et une composante $H^{red}$, dite réduite, dépendante du matériau, résultant de l'aimantation $M(P')$ en tous les autres point $P'$ de la coque.

L'excitation magnétique réduite $H^{red}$ possède des propriétés mathématiques qui sont analogues à celles d'un champ électrostatique. En particulier, $H^{red}$ dérive d'un potentiel $\varphi : H^{red} = - gradc\varphi$

Modèle de la coque

On considère que la coque est un milieu ferromagnétique mince, se réduisant à une surface $S$, d'épaisseur $e$.

Conditions de passage à travers la coque

La caractéristique principale des matériaux ferromagnétiques est leur capacité à canaliser le flux de l'excitation magnétique. Cette propriété est amplifiée lorsque l'épaisseur du matériau ferromagnétique est réduite par rapport aux autres dimensions caractéristiques du matériau et si la perméabilité magnétique $\chi$ du matériau est importante.

Ces conditions étant vérifiées dans le cas de la coque d'un navire, la composante normale $H_n$ de l'excitation magnétique totale $H$ est nulle, c'est-à-dire que l'excitation magnétique totale $H$ dans le matériau est considérée comme tangente à la coque, et sa composante tangentielle $H_r$ est constante dans l'épaisseur de la coque.

Les conditions de passage à la première interface entre le matériau de la coque et le volume situé à l'extérieur de la coque (indice 1 sur la figure 1), les conditions de passage à la seconde interface entre le matériau de la coque et le volume situé à l'intérieur de la coque (indice 2 sur la figure 1), et l'hypothèse que la coque se réduit à une surface $S$ conduisent à écrire la continuité du potentiel $\varphi$ et la discontinuité de la dérivée normale $\dfrac{\partial \varphi}{\partial n}$ du potentiel $\varphi$ au passage de la surface $S$ :

$$\varphi_1 = \varphi_2$$

$$\frac{\partial \varphi_1}{\partial n} - \frac{\partial \varphi_2}{\partial n} \neq 0$$

Modélisation des sources magnétiques

L'excitation magnétique réduite $H^{red}$ se comportant comme un champ électrostatique, les sources de cette excitation réduite $H^{red}$ sont modélisées soit par des distributions de sources monopolaires, soit par des distributions de sources dipolaires, comme cela est connu de l'homme du métier pour modéliser les champs électrostatiques.

Les distributions de sources acceptables doivent répondre aux conditions de passages indiquées ci-dessus.

Distribution surfacique de charges

La première distribution satisfaisant aux conditions de passage est la distribution surfacique de charges ou distribution de sources monopolaires, notée *q(P)*.

Les conditions de passage s'écrivent alors :

$$\varphi_1 = \varphi_2$$

$$\frac{\partial \varphi_1}{\partial n} - \frac{\partial \varphi_2}{\partial n} = -q(P)$$

Au passage de la surface *S*, l'excitation magnétique réduite *H*<sup>red</sup> suit l'équation : $H^{red}{}_1 - H^{red}{}_2 = q(P).\vec{n}$ , où les indices 1 et 2 font respectivement référence au volume extérieur et au volume intérieur délimité par la surface *S* de la coque, et $\vec{n}$ est le vecteur normal à la surface *S* , au point *P* de la surface *S*.

Cette équation vectorielle indique qu'il y a conservation de la composante tangentielle de l'excitation magnétique réduite *H*<sup>red</sup>, et saut de sa composante normale, à la traversée de la surface *S*.

Une telle distribution de sources monopolaires crée, en un point *R* quelconque, un potentiel réduit et une excitation magnétique réduite :

$$\varphi(R) = \frac{1}{4\pi} \iint_s \frac{q(P)}{|PR|} dS(P)$$

$$H^{red}(R) = \frac{1}{4\pi} \iint_s q(P) \frac{PR}{PR^3} dS(P) \tag{1}$$

où *P* est un point courant de la surface S de la coque ; et *PR* est le vecteur joignant les points *P* et *R* .

Distribution surfacique de dipôles tangentiels

La surface *S* de la coque porte une distribution surfacique de sources dipolaires, notée $\vec{p}(P)$ en un point *P* de la surface *S*. Les conditions de passage pour cette distribution s'écrivent :

$$\varphi_1 - \varphi_2 = p_n(P)$$

$$\frac{\partial \varphi_1}{\partial n} - \frac{\partial \varphi_2}{\partial n} = -div_S \, \bar{p}_t(P)$$

où $p_n(P)$ et $\bar{p}_t(P)$ représentent respectivement la composante normale et la composante tangentielle à la surface *S* de la distribution $\bar{p}(P)$ ; et *div*<sub>S</sub> l'opérateur divergence contraint sur la surface *S*.

Ainsi, une distribution surfacique de sources dipolaires $\vec{p}(P)$ qui sont tangentielles à la surface *S* de la coque satisfait aux conditions de passage à travers la surface *S*. Dans ce qui suit l'indice t sera omis.

Au passage de la surface *S*, l'excitation magnétique réduite *H*<sup>red</sup> suit l'équation :

$$H^{red}{}_1 - H^{red}{}_2 = -[div_S \, \bar{p}(P)].\bar{n}$$

Une telle distribution de sources dipolaires crée, pour un point *R* quelconque, un potentiel réduit et une excitation

réduite :

$$\varphi(R) = \frac{1}{4\pi} \iint_s \vec{p}(P) . \frac{PR}{PR^3} dS(P)$$

$$H^{red}(R) = \frac{1}{4\pi} \iint_s grad(\vec{p}(P) . \frac{PR}{PR^3}) dS(P) \qquad (2)$$

où $P$ est un point courant de la surface $S$ de la coque ; et $PR$ est le vecteur joignant les points $P$ et $R$.

remarques

Ces deux distributions de sources, en charge et en dipôles, représentent le même phénomène physique et créent la même excitation magnétique en tout point $R$. Cela impose que : $div_S\vec{p}(P) = -q(P)$

De plus, un volume $\Omega$ aimanté crée un potentiel ayant pour expression :

$$\varphi(R) = \frac{1}{4\pi} \iiint_\Omega M(P) . \frac{PR}{PR^3} d\Omega(P)$$

où $M(P)$ est l'aimantation en un point $P$ du matériau.

La grandeur $M(P)$ étant constante le long de l'épaisseur $e$ de la tôle, l'intégrale volumique peut être remplacée par une intégrale surfacique. On passe d'une intégrale triple sur le volume élémentaire $d\Omega$ de la coque, à une intégrale double sur une surface élémentaire $dS$ (qui n'est pas un vecteur).

La comparaison de l'expression du potentiel en fonction de $\vec{p}$ et de l'expression du potentiel en fonction de $M$ conduit à : $\vec{p} = eM$, tandis que, la relation entre $\vec{p}$ et $q$ conduit à : $q = -ediv_S M$.

Modélisation continue des phénomènes physiques

Première modélisation

La distribution d'aimantation $M(P)$ dans la coque, qui est la somme de l'aimantation induite $M^{ind}$ et de l'aimantation rémanente $M^{rem}$, génère une excitation magnétique en un point $R$ dans l'air qui prend, d'après l'équation (2), la forme :

$$H(R) = H_0(R) + H^{red}(R) = H_0(R) + \frac{1}{4\pi} \iiint_\Omega grad(M(P) . \frac{RP}{RP^3}) d\Omega(P) \qquad (3)$$

En inversant cette relation, la première modélisation, couramment dénommé modélisation du problème inverse, permet de déterminer la distribution d'aimantation $M(P)$, à partir d'une pluralité de mesures de l'excitation magnétique en des points $R$ déterminés et de la connaissance de l'excitation magnétique inductrice $H_0(R)$.

Seconde modélisation

L'aimantation induite $M^{ind}$ en un point $P$ de la coque est proportionnelle à l'excitation magnétique totale $H(P)$ en ce point $P$ :

$$M^{ind}(P) = \chi H(P)$$

Soit :

$$M^{ind}(P) = \chi[H_0(P) + \frac{1}{4\pi}\iiint_\Omega grad(M(P').\frac{PP'}{PP'^3})d\Omega(P')] \qquad (4)$$

Cette relation traduit le comportement du matériau. Elle couple la réponse du matériau au point $P$ , c'est-à-dire l'aimantation induite $M^{ind}(P)$ au point $P$ , avec l'aimantation totale $M(P')=M^{ind}(P')+M^{rem}(P')$ en chacun des autres points $P'$ de la coque.

Discrétisation des première et seconde modélisations

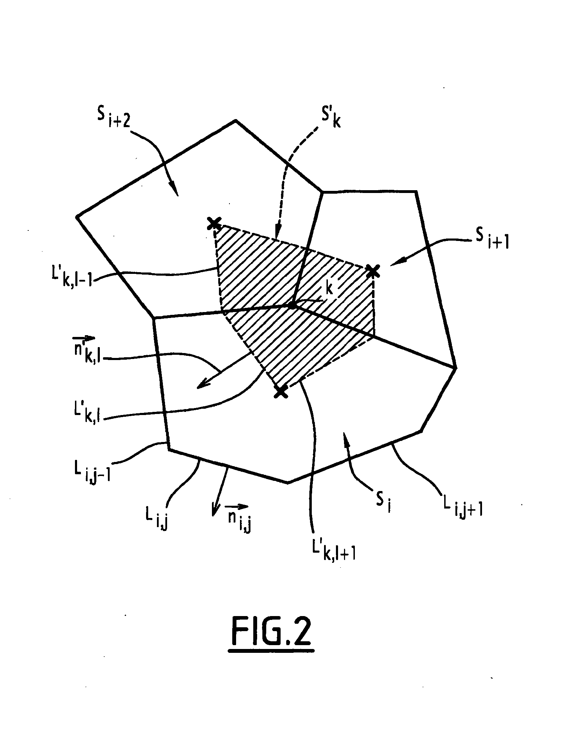

Les distributions surfaciques de sources magnétiques sont discrétisées.
Pour ce faire, un modèle virtuel de la coque est utilisé. Ce modèle comporte un maillage constitué par une pluralité de surfaces élémentaires qui constituent une approximation de la surface $S$ .
Ce maillage comportant $N$ surfaces élémentaires $S_i$ polygonales et planes.
Chaque surface élémentaire $S_i$ est limitée par une pluralité d'arêtes $L_{i,j}$. Les arêtes des différentes surfaces se rejoignent en $N'$ noeuds $k$ (cf. figure 2).

Sources dipolaires

La distribution de sources dipolaires $\vec{p}(P)$, où $P$ est un point courant de la surface $S$ de la coque du navire, est considérée comme uniforme sur chaque surface élémentaire $S_i$ du maillage. Elle est écrite $\vec{p_i}$.

Avec $\vec{p}_i = eM_i = eM_i^{ind} + eM_i^{rem} = \vec{p}_i^{ind} + \vec{p}_i^{rem}$ , la discrétisation de l'équation (3) conduit à :

$$H(R) = H_0(R) + \frac{1}{4\pi}\sum_i^N \iint_{s_i} grad_S(\vec{p}_i(P).\frac{RP}{RP^3})dS_i(P)$$

où $PR$ est le vecteur reliant le point P, de la surface élémentaire $S_i$, au point $R$.
Avec :

$$\iiint_{\Omega_i} grad(M_i(P).\frac{PR}{PR^3})d\Omega_i(P) = \iint_{S_i^{ext}} grad_s(\vec{p}_i(P).\frac{PR}{PR^3})d\vec{S}_i^{ext}(P)$$

Où $\Omega_i$ est un volume élémentaire de la coque obtenu par translation de la surface élémentaire $S_i$ sur une longueur égale à l'épaisseur e le long d'une normale à la surface élémentaire S$_i$. $S_i^{ext}$ est la surface extérieure fermée de ce volume élémentaire $\Omega_i$, orientée de l'intérieur vers l'extérieur.
En considérant les différentes grandeurs comme constantes selon l'épaisseur e du volume $\Omega_i$, l'expression précédente devient :

$$\iint_{s_i} grad_s(\vec{p}_i(P).\frac{PR}{PR^3})dS_i(P) = \sum_j \int_{L_{i,j}} (\vec{p}_i(P)\vec{n}_{i,j})\frac{PR}{PR^3}dL_{i,j}(P)$$

où $\overline{n}_{i,j}$ est la normale le long de l'arête $L_{i,j}$, située dans le plan de la surface élémentaire $S_i$ et orientée vers l'extérieur de cette surface élémentaire. Dans ce qui suit, pour plus de clarté, les indices j sur les différentes arêtes d'une même surface élémentaire sont omis, la somme sur les différentes intégrales linéaires devenant une intégrale de contour. D'où,

$$H(R) = H_0(R) + \frac{1}{4\pi} \sum_i^N \int_{L_i} [(\vec{p}_i^{\ ind}(P) + \vec{p}_i^{\ rem}(P))\vec{n}_i] \frac{PR}{PR^3} dL_i(P) \qquad (5)$$

Ou, sous forme matricielle :

$$\begin{pmatrix} A_M & A_M \end{pmatrix} \begin{pmatrix} \vec{p}_i^{\ ind} \\ \vec{p}_i^{\ rem} \end{pmatrix} = m$$

Avec :

- $m$ un vecteur dont la $j^{ème}$ composante est la différence $H(R_j)$-$H_0(R_j)$ entre la mesure de l'excitation magnétique effectuée au point $R_j$ où est placé le $j^{ème}$ capteur, et la valeur de l'excitation magnétique inductrice au point $R_j$; et,
- $A_M$ la matrice dont l'élément $A_{Mji}$ est l'opérateur associé à une surface élémentaire

$$S_i : \frac{1}{4\pi} \int_{L_i} (u_i.\vec{n}_i) \frac{R_i R_j}{R_i R_j^3} dL_i(R_i) \ .$$

Où $u_i$ est un doublet de vecteur formant une base associée à la surface élémentaire $S_i$ de décomposition des $\vec{p}_i$

En utilisant l'équation (4), en un point P de la surface élémentaire $S_i$ , on a :

$$\vec{p}_i^{\ ind}(P) = eM_i^{\ ind}(P) = e\chi H_{0i} + \frac{\chi}{4\pi} \sum_j^N \iint_{S_j} grad_S(\vec{p}_j(P').\frac{PP'}{PP'^3}) dS_j(P')$$

où il a été considéré que l'excitation inductrice $H_0(P)$ est uniforme sur la surface $S_i$ et vaut $H_{0i}$.
Avec

$$\iint_{S_j} grad_S(\vec{p}_j(P').\frac{PP'}{PP'^3}) dS_j(P') = \int_{L_j} (\vec{p}_j(P').\vec{n}_j) \frac{PP'}{PP'^3} dL_j(P') \ ,$$

il vient finalement :

$$\frac{\vec{p}_i^{\ ind}(P)}{e} - \frac{\chi}{4\pi} \sum_j^N \int_{L_j} (\vec{p}_j(P').\vec{n}_j) \frac{PP'}{PP'^3} dL_j(P') = e\chi H_{0i}$$

Que l'on peut écrire sous forme matricielle :

$$\begin{pmatrix} Id + D_M & D_M \end{pmatrix} \begin{pmatrix} \vec{p}_i^{\ ind} \\ \vec{p}_i^{\ rem} \end{pmatrix} = S_M$$

Avec :

- $S_M$ un vecteur dont la $^{ème}$ composante est proportionnelle à l'excitation magnétique inductrice $e\chi H_{0i}$ en un point de la $i^{ème}$ surface élémentaire du maillage ; et,

- $D_M$ la matrice dont l'élément $D_{Mji}$ est l'opérateur $-\dfrac{\chi e}{4\pi}\displaystyle\int_{L_i}(u_i.\vec{n}_i)\dfrac{R_j R_i}{\left|R_j R_i\right|^3}dL_i(R_i)$,

où $R_j$ est la position du barycentre de la surface élémentaire $S_j$.

Ces équations sont vectorielles. En considérant uniquement sa projection dans le plan de chaque surface élémentaire, cela conduit à un système de 2N équations à 2N inconnues. Ces équations relatives au comportement magnétique du matériau constituent ce que nous appelons la seconde modélisation.

Sources monopolaires

Dans la description monopolaire, les charges sont sensiblement proportionnelles au flux magnétique s'échappant à l'interface entre la tôle et l'air. Or, l'excitation magnétique dans la tôle étant orientée tangentiellement, le flux magnétique tend à s'échapper majoritairement par les arêtes du modèle de coque. Le procédé prévoit la réalisation d'un bilan du flux magnétique sur chacune des arêtes d'un maillage dual associé aux surfaces élémentaires $S_i$ du maillage primaire. Les éléments relatifs à ce maillage dual seront primés dans ce qui suit. Le maillage dual comporte $N'$ surfaces élémentaires $S'_k$, chacune étant associée à un noeud $k$ du maillage primaire.

Comme cela est représenté sur la figure 2, une surface élémentaire duale $S'_k$ est associée à un noeud du maillage primaire. Chaque surface élémentaire duale $S'_k$ est construite à partir des barycentres des différentes surfaces élémentaires $S_i$ contenant le noeud $k$ considéré et les milieux des arêtes partant de ce noeud $i$.

La charge $Q_k$ condensée au noeud $k$ est définie par :

$$Q_k = \iint_{S'_k} q\, dS'_k$$

où $S'_k$ est la surface élémentaire duale associée au noeud $k$ du maillage primaire.

La discrétisation de l'équation (1) conduit à :

$$H(R) = H_0(R) + \frac{1}{4\pi}\sum_k^{N'} Q_k(R_k)\frac{R_k R}{R_k R^3}$$

Où le point $R_k$ correspond à la position du noeud $k$.

En distinguant charge induite et charge rémanente dans la charge totale $Q_k$, c'est-à-dire $Q_k = Q_k^{ind} + Q_k^{rem}$, il vient :

$$H(R) = H_0(R) + \frac{1}{4\pi}\sum_k^{N'}\left(Q_k^{ind}(R_k) + Q_k^{rem}(R_k)\right)\frac{R_k R}{R_k R^3} \tag{6}$$

ou encore, sous une forme matricielle :

$$\begin{pmatrix} A_Q & A_Q \end{pmatrix}\begin{pmatrix} Q_i^{ind} \\ Q_i^{rem} \end{pmatrix} = m$$

Avec :

- $m$ un vecteur dont la $j^{ème}$ composante est la différence $H(R_j)-H_0(R_j)$ entre la mesure de l'excitation magnétique effectuée au point $R_j$ où est placé le $j^{eme}$ capteur et la valeur de l'excitation magnétique inductrice au point $R_j$; et,

- $A_Q$ la matrice dont le coefficient $A_{Qki}$ est l'opérateur associé à une surface élémentaire duale $S'_k$ : $\dfrac{1}{4\pi}\dfrac{R_k R_i}{R_k R_i^3}$.

Pour la discrétisation de la seconde modélisation couplant les charges monopolaires entre elles, on a :

$$q = -e\, div_S M$$

$$Q_k = \iint_{S'_k} q\, dS'_k = -e\iint_{S'_k} div_S M\, dS'_k$$

$$Q_k^{ind} = -e\iint_{S'_k} div_S M^{ind}\, dS'_k$$

En utilisant l'équation (4), on a :

$$Q_k^{ind} = -e\iint_{S'_k} div_S[\chi H_0(P) + \chi H^{red}(P)]dS'_k(P)$$

Puis, en injectant l'équation (6) dans l'équation précédente, on a :

$$Q_k^{ind} + \frac{e\chi}{4\pi}\left(\sum_l^{N'}\left(Q_l^{ind} + Q_l^{rem}\right)\iint_{S'_k} div_S[\frac{R_l P}{R_l P^3}]dS'_k(P)\right) = -e\iint_{S'_k} div_S[\chi H_0(P)]dS'_k(P)$$

Enfin, en appliquant la formule d'Ostogradski à un volume élémentaire correspondant à l'extrusion, sur une épaisseur $e$, de la surface élémentaire $S'_k$ du maillage duale associée au nœud $k$, soit :

$$-e\iint_{S'_k} div_S V\, dS'_k = -e\int_{L'_k} V.\vec{n}'_k\, dL'_k$$

où $\overline{n}'_k$ est une normale à l'arête $L'_k$ se situant dans le plan de la surface élémentaire associée, il vient :

$$Q_k^{ind}(R_k) + \frac{e\chi}{4\pi}\left(\sum_l^{N'}\left(Q_l^{ind}(R_l) + Q_l^{rem}(R_l)\right)\int_{L'_k}\frac{R_l R_k}{R_l R_k^3}.\vec{n}'_k.dL'_k(R_k)\right) = -e\chi\int_{L'_k} H_0(R_k).\vec{n}_k\, dL'_k(R_k)$$

(7)

ou sous une forme matricielle :

$$\left(Id + D_Q \quad D_Q\right)\begin{pmatrix} Q_i^{ind} \\ Q_i^{rem} \end{pmatrix} = S_Q 2$$

Avec :

- $S_Q$ un vecteur dont la $k$ème composante est donnée par l'expression

- $e\chi \int_{L'_k} H_0(R_k).\overline{n}_k dL'_k (R_k)$ relative à la $k$ème surface élémentaire duale $S'_k$ ; et ;

- $D_Q$ la matrice dont le coefficient $D_{Qji}$ est l'opérateur $\dfrac{e\chi}{4\pi}\displaystyle\int_{L'_j} \dfrac{R_i R_j}{R_i R_j^{\;3}}.\vec{n}'_j \, dL'_j (R_j)$.

Equations à résoudre

De manière synthétique, les équations à résoudre sont les suivantes : Dans la description en sources dipolaires :

$$\begin{pmatrix} A_M & A_M \\ D_M + Id & D_M \end{pmatrix}\begin{pmatrix} p_i^{\,ind} \\ p_i^{\,rem} \end{pmatrix} = \begin{pmatrix} m \\ S_M \end{pmatrix} \qquad\qquad (A)$$

Dans la description en sources monopolaires :

$$\begin{pmatrix} A_Q & A_Q \\ D_Q + Id & D_Q \end{pmatrix}\begin{pmatrix} Q_i^{\,ind} \\ Q_i^{\,rem} \end{pmatrix} = \begin{pmatrix} m \\ S_Q \end{pmatrix} \qquad\qquad (B)$$

La solution de ces systèmes d'équations n'est pas unique puisque, dans la plupart des cas, le nombre de capteurs utilisés (i.e. ne nombre de coordonnées du vecteur $m$) est moins important que le nombre de sources recherchées (i.e. $N$ sources dipolaires et $N'$ sources monopolaires). Pour obtenir une solution, une procédure de décomposition en valeurs singulières (acronyme SVD en anglais) est utilisée. Cet outil mathématique, connu de l'homme du métier, permet de déterminer, parmi toutes les solutions possibles, la solution de norme minimale. De préférence une norme quadratique est utilisée dans cette procédure de décomposition en valeurs singulières.
Une fois la solution obtenue, le champ magnétiques sur la surface de référence est évaluée grâce aux équations (5), système d'équation (A), ou (6), système d'équations (B).

Transformation de passage de la description en sources dipolaires à la description en sources monopolaires

Selon le procédé de l'art antérieur, on résout un système d'équations conforme à l'un ou l'autre des systèmes d'équations (A) et (B). La solution obtenue est relativement précise dans le cas où les capteurs du champ magnétique sont suffisamment éloignés de la coque du navire. Dans le cas contraire, où les capteurs sont proches ou collés à la coque du navire, la solution obtenue est faussée et n'est par conséquent pas satisfaisante.
Le procédé selon l'invention résout un autre système d'équations (C). Le système d'équations (C) dérive de la combinaisons des deux systèmes d'équation (A) et (B), de manière à modéliser de manière précise et robuste à la fois l'aspect vectoriel du problème, en particulier le lien entre les mesures du champs magnétique et les sources, et l'aspect scalaire du problème, en particulier le couplage mutuel entre les sources à la surface de la coque. La solution obtenue par la résolution du système d'équations (C) est précise, même lorsque les capteurs du champ magnétique sont positionnés à proximité de la coque.
Pour cela, le procédé selon l'invention utilise une transformation $T$ permettant de passer de la distribution de sources dipolaires $\vec{p}_i$ à la distribution de sources monopolaires $Q_k$ : $(Q_k)=T(\vec{p}_i)$.
Avec :

$$Q_k = \iint\limits_{S_k'} q(P) dS'_k (P) \text{ et } q(P) = -div_s \vec{p}(P)$$

On montre que :

$$Q_k = \sum_{l}^{d_k} \vec{p}_l \cdot \int_{L'_{k,l}} \overrightarrow{n'_{k,l}} dL'_{k,l} (P) \quad (7)$$

Où :

- $d_k$ est le nombre d'arêtes duales $L'_{k,l}$ associées à la surface élémentaire duale $S'_k$ du noeud k ;
- $\overline{n_{k,l}}$ la normale sortante à l'arête duale $L'_{k,l}$ considérée ; et ,
- $\overline{p_l}$ la valeur de l'aimantation dipolaire tangentielle le long de l'arête duale $L'_{k,l}$ considérée, cette aimantation étant constante le long d'une arête duale et correspondant à l'aimantation de la surface élémentaire $S_i$ sur laquelle se trouve l'arête duale considérée.

En appliquant la relation (7) à tous les éléments du maillage, une matrice T est obtenue permettant de passer de la distribution en sources dipolaires à la distribution en sources monopolaires : $(Q_k) = T(\vec{p_i})$

Les coefficients de la matrice T dépendent de la géométrie du maillage primaire choisi.

La pseudo-inverse $T^*$ de la transformation T, c'est-à-dire la généralisation de la matrice inverse aux matrices qui ne sont pas carrées, permet de passer de la distribution en sources monopolaires à une distribution de sources dipolaires : $(\vec{p_i}) = T^*(Q_i)$.

En utilisant, de plus, la transformation T uniquement pour les aimantations rémanentes, le système d'équations (C) s'écrit :

$$\begin{pmatrix} A_M & A_M T^* \\ D_M + Id & D_M . T^* \end{pmatrix} \begin{pmatrix} \vec{p}_i^{ind} \\ Q_i^{rem} \end{pmatrix} = \begin{pmatrix} m \\ S_M \end{pmatrix} \qquad (C)$$

avec :

- $m$ le vecteur dont la i$^{ème}$ composante est la différence $H(R_j)-H_0 (R_j)$ entre la mesure de l'excitation magnétique effectuée au point $R_j$ par le i$^{ème}$ capteurs de champ magnétique et la valeur de l'excitation magnétique inductrice au point $R_j$ ;

- $A_M$ la matrice dont l'élément $A_{M\,ij}$ est l'opérateur $\dfrac{1}{4\pi}\int_{L_i} (u_i.\vec{n}_i)\dfrac{R_iR_j}{|R_iR_j|^3}dL_i(R_i)$ associé à une surface élémentaire $S_i$ du maillage primaire, ayant une pluralité d'arêtes $L_i$ , présentant chacune une normale $\overline{n}_i$ dans le plan de la surface élémentaire $S_i$ qui est orientée vers l'extérieur de cette surface élémentaire, et où $u_i$ est un doublet de vecteur formant une base de décomposition de la surface élémentaire $S_i$ ;

- $S_M$ le vecteur dont la i$^{ème}$ composante est proportionnelle à l'excitation magnétique inductrice $e\chi H_{0i}$ en un point de la i$^{ème}$ surface élémentaire $S_i$ du maillage ; et,

- $D_M$ la matrice dont l'élément $D_{M\,ij}$ est l'opérateur $-\dfrac{\chi e}{4\pi}\int_{L_j} (u_j.\vec{n}_j)\dfrac{R_iR_j}{|R_iR_j|^3}dL_j(R_j)$ ; et,

- $T$ la matrice de transformation, telle que $(Q_i^{rem}) = T(\vec{p}_i^{rem})$, dont la pseudo-inverse est notée $T^*$.

Les inconnues $\vec{p}_i^{ind}$ sont d'abord éliminées du système. On a :

$$(\vec{p}_i^{ind}) = (D_M + Id)^{-1}.(S_M - D_M T^*)(Q_i^{rem}) \qquad (8)$$

et, par conséquent :

$$(Q_i^{rem}) = ((-A_M.(D_M + Id)^{-1}.D_M + A_M)T*)*.(m - A_M.(D_M + Id)^{-1}S_M) \qquad (9)$$

Un système d'équations similaire pourrait être écrit à partir des $A_Q$ et des $D_Q$ du système d'équations (B).

Rééquilibrage du poids des sources

Pour donner le même poids à toutes les surfaces élémentaires du maillage primaire lors de la résolution du système d'équations (C), et afin de ne pas biaiser la solution en favorisant une surface élémentaire se situant en regard d'un capteur 7 du champ magnétique par rapport aux autres surfaces élémentaires du maillage primaire, le procédé selon l'invention prévoit une procédure de rééquilibrage du système d'équations (C).
Pour cela, une procédure, par ailleurs connue en elle-même, de préconditionnement des matrices rectangulaires est utilisée.
D'une manière générale, soit $A$ une matrice quelconque rectangulaire. On appelle $W_g$ et $W_d$ les matrices carrées diagonales dont les termes sont respectivement les inverses des normes des lignes et des colonnes de $A$. La matrice $A_1$ est alors définie par: $A_1 = W_g.A.W_d$
Cette procédure tend à diminuer l'influence des coefficients les plus importants de la matrice $A$.
Dans le cas de l'équation (9), la procédure de préconditionnement porte, de préférence, sur la matrice - $A_M.(D_M + Id)^{-1}.D_M + A_M)T*$.
En appliquant la procédure de préconditionnement à ce dernier ensemble d'équations, on obtient :

$$(Q_i^{rem}) = W_d(W_g.((-A_M.(D_M + Id)^{-1}.D_M + A_M).T*.W_d)*.W_g.(m - A_M.(D_M + Id)^{-1}S_M)$$

Les inconnues $Q_i^{rem}$ sont obtenues au moyen de l'expression précédente , puis les inconnues $\vec{p}_i^{ind}$ sont calculées à partir de l'équation (8).
Finalement, le champ magnétique créé par la coque du navire dans le plan de référence est calculé au moyen de la partie correspondante de l'équation (6) pour la contribution des sources monopolaires rémanentes $Q_i^{rem}$ et au moyen de la partie correspondante de l'équation (5) pour la contribution des sources dipolaires induites $\vec{p}_i^{ind}$ .
Les étapes précédentes du procédé de détermination de l'aimantation de la coque du navire et du procédé de détermination de la signature du navire constituent les étapes nécessaires d'un procédé d'immunisation magnétique du navire consistant à réguler, en temps réel, la signature magnétique du navire.
Pour réguler la signature magnétique du navire, de préférence pour minimiser la signature magnétique du navire, les moyens de calcul du navire déterminent une pluralité de courants électriques adaptés destinés à être respectivement appliqués aux boucles d'immunisation dont est équipé le navire.
Les moyens de calcul transmettent ces courants électriques adaptés en tant que consignes aux moyens d'alimentation des différentes boucles d'immunisation. Les moyens d'alimentation appliquent en entrée de chacune des boucles un courant correspondant au courant adapté requis.
En conséquence de quoi, les courants circulant dans les différentes boucles d'immunisation génèrent une excitation magnétique inductrice modifiant l'excitation magnétique totale $H_0$.
Une fois les courants électriques établis, le procédé de détermination de l'aimantation de la coque du navire est exécuté à nouveau en prenant en compte cette modification de l'excitation magnétique $H_0$, de manière à déterminer une nouvelle valeur de l'aimantation. Puis le procédé de détermination de la signature du navire est itéré avec la nouvelle valeur probable de la distribution de l'aimantation à la surface de la coque.
Par itérations successives, la signature magnétique du navire est minimisée.
Par ailleurs, dans une variante de réalisation du procédé de détermination de l'aimantation, la procédure de décomposition en valeurs singulières (SVD) est modifiée. Dans une SVD classique, on cherche une solution qui minimise un critère prédéfini utilisant une norme, telle que « les moindres carrés ». Dans la présente variante de réalisation, on cherche une solution dont l'écart avec une solution de référence minimise le critère choisi.
Cette distribution de référence est avantageusement la distribution de norme minimale déterminée lors d'une itération précédente du procédé de détermination de l'aimantation.
Cette distribution de référence peut également être une distribution de sources magnétiques mesurée au moyen d'un dispositif adapté à un moment de l'histoire magnétique du navire. Cette mesure peut par exemple être réalisée dans un chantier naval, avant que le navire prenne la mer, au moyen d'un dispositif fixe.

De cette manière, est transcrite l'idée qu'entre les instants t-$\delta$t et t, la distribution d'aimantation à la surface de la coque a évolué à partir de la distribution d'aimantation à t - $\delta$t, c'est-à-dire la distribution de référence, et que la distribution à l'instant t ne doit pas être très « éloignée » de la distribution de référence.

Il est à remarquer que cette variante du procédé de détermination de l'aimantation de la coque est indépendante du système d'équations que l'on cherche à résoudre. Elle pourrait être mise en oeuvre pour d'autres systèmes d'équations tels que les systèmes (A) ou le système (B).

Cette variante présente l'avantage de conduire à une distribution d'aimantation de norme minimale plus robuste que dans la procédure de décomposition en valeurs singulières classiquement utilisée. Il est à noter qu'il a été constaté que la solution obtenue par la mise en oeuvre de la présente invention est beaucoup plus robuste que les solutions obtenues par les méthodes de résolution de l'art antérieur, et ceci quelle que soit la distance à laquelle se trouve les capteurs de la surface de la coque ferromagnétique. Par le qualificatif de « robuste », on entend classiquement le fait que la solution soit peu ou pas modifiée par des perturbations ou bruits.

La mise en oeuvre du procédé de détermination de l'aimantation de la coque d'un navire selon la présente invention a été réalisée sur une maquette au 1/30$^{ème}$ d'un sous-marin à double coque.

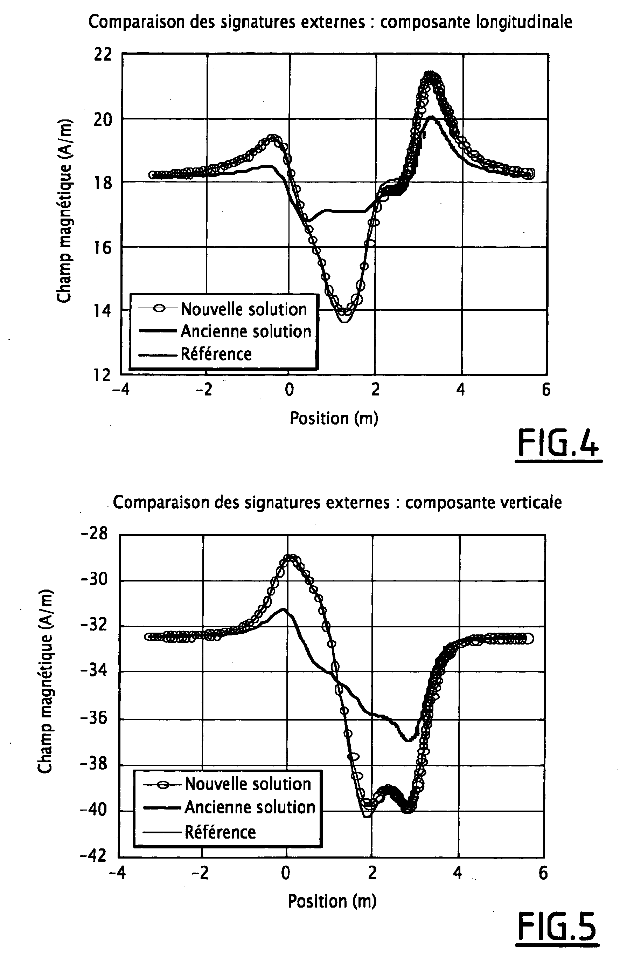

Les figures 4 et 5 sont des graphes permettant de comparer la signature de la coque calculée selon le précédé de l'art antérieur et selon le procédé de l'invention avec la signature réelle mesurée par un capteur. La signature est ici évaluée le long d'un axe parallèle à l'axe longitudinal de la coque et situé 10 mètres au-dessous de celle-ci, la position 0 correspondant à la verticale du centre de gravité de la coque. Le graphe de la figure 4 représente la composante longitudinale du champ magnétique tandis que le graphe de la figure 5 représente la composante verticale de ce même champ. Les capteurs du champ magnétique sont collés sur la paroi extérieure de la coque interne du sous-marin. On constate une très grande corrélation entre la signature calculée selon la présente invention et la signature réelle du navire.

Le procédé selon l'invention permettant de calculer précisément la signature en rapprochant les capteurs de la coque, ceux-ci sont avantageusement disposés à l'extérieur de la coque ferromagnétique du navire. Par exemple, dans le cas d'un sous-marin comportant une coque interne ferromagnétique et une coque externe hydrodynamique, les capteurs sont avantageusement placés entre les deux coques. Cette disposition permet de réduire, à l'intérieur de la coque interne, l'encombrement causé par les capteurs et leurs connexions électriques. De plus, la coque interne constituant un blindage magnétique, elle permet de réduire considérablement, voir d'annuler, à l'extérieur de celle-ci, les champs magnétiques secondaires générés par les sources secondaires intérieures, telles que les moteurs. Les mesures de champ magnétique réalisées par des capteurs situés à l'extérieur de la coque interne se rapprochent ainsi davantage du champ magnétique d'intérêt, c'est-à-dire le champ magnétique généré par la distribution d'aimantation à la surface de la coque. La solution à laquelle conduit le procédé selon l'invention n'en est que plus juste.

Au sens de l'invention, les termes « proche de la coque » ou « collé à la coque » appliqués à un capteur du champ magnétique signifie que l'élément sensible au champ magnétique de ce capteur est placé entre 0 et 10 cm de la surface orientée vers l'extérieur du navire ou de la surface orientée vers l'intérieur du navire de la coque ferromagnétique dont on cherche à calculer la signature.

## Revendications

1. Procédé de détermination, en temps réel, de l'aimantation de la coque d'un navire, la coque du navire étant en matériau ferromagnétique et soumise à une excitation magnétique inductrice et le navire étant muni d'une pluralité de capteurs du champ magnétique positionnés en des points déterminés par rapport à la coque, comportant les étapes consistant à :

   a) - acquérir une pluralité de mesures du champ magnétique au moyen de la pluralité de capteurs ;
   b) - évaluer l'excitation magnétique inductrice ; et,
   c) - déterminer, en résolvant un système d'équations résultant de la modélisation des phénomènes physiques mis en jeu, à partir de la pluralité de mesures acquises et de l'excitation magnétique inductrice évaluée, une distribution de sources magnétiques probable à la surface de la coque,

   **caractérisé en ce que**, dans ladite modélisation, les sources magnétiques induites sont décrites par une distribution de sources dipolaires et les sources magnétiques rémanentes sont décrites par une distribution de sources monopolaires, et **en ce que** ladite modélisation comporte :

   - une première modélisation associant à des mesures du champ magnétiques, une distribution d'aimantation dans le matériau ferromagnétique ; et,
   - une seconde modélisation relative au comportement du matériau ferromagnétique, décrivant le couplage entre une source magnétique en un point du matériau, avec une source magnétique en un autre point du matériau.

**2.** Procédé selon la revendication 1, **caractérisé en ce que** le procédé utilise une transformation *T* permettant d'associer à une distribution de sources dipolaires au moins une distribution de sources monopolaires et/ou une transformation *T*\* permettant d'associer à une distribution de sources monopolaires, au moins une distribution de sources dipolaires.

**3.** Procédé selon la revendication 2, **caractérisé en ce que** ladite modélisation utilise un modèle virtuel de la coque du navire comportant un maillage primaire constitué d'une pluralité de surfaces élémentaires planes et polygonales.

**4.** Procédé selon la revendication 3, **caractérisé en ce que**, par surface élémentaire du maillage primaire, la distribution de sources dipolaires est uniforme et tangentielle à cet élément de surface.

**5.** Procédé selon la revendication 3 ou la revendication 4, **caractérisé en ce que** la distribution de sources monopolaires est discrétisée au noeuds du maillage primaire.

**6.** Procédé selon les revendications 4 et 5 en combinaison, **caractérisé en ce que** ledit système d'équations à résoudre s'écrit :

$$
\begin{pmatrix} A_M & A_M.T* \\ D_M + Id & D_M.T* \end{pmatrix} \begin{pmatrix} p_i^{ind} \\ \overline{Q_i^{rem}} \end{pmatrix} = \begin{pmatrix} m \\ S_M \end{pmatrix}
$$

avec :

- *m* un vecteur dont la i$^{\text{ème}}$ composante est la différence $H(R_j)-H_0(R_j)$ entre la mesure de l'excitation magnétique effectuée au point $R_j$ par le i$^{\text{ème}}$ capteurs de champ magnétique et la valeur de l'excitation magnétique inductrice au point $R_j$;

- $A_M$ une matrice dont l'élément $A_{Mji}$ est l'opérateur $\dfrac{1}{4\pi} \displaystyle\int_{L_i} (u_i.\vec{n}_i) \dfrac{R_i R_j}{R_i R_j{}^3} dL_i(R_i)$ associé à une surface élémentaire $S_i$ du maillage primaire ayant une pluralité d'arêtes $L_i$, présentant chacune une normale $\overline{n}_i$ dans le plan de la surface élémentaire $S_i$ et orientée vers l'extérieur de cette surface élémentaire, et où $u_i$ est un doublet de vecteur formant une base de la surface élémentaire ;

- $S_M$ un vecteur dont la i$^{\text{ème}}$ composante est proportionnelle à l'excitation magnétique inductrice $e\chi H_{0i}$ en un point de la i$^{\text{ème}}$ surface élémentaire du maillage primaire ;

- $D_M$ une matrice dont l'élément $D_{Mji}$ est l'opérateur $-\dfrac{\chi e}{4\pi} \displaystyle\int_{L_i} (u_i.\vec{n}_i) \dfrac{R_j R_i}{\left| R_j R_i \right|^3} dL_i(R_i)$ ; et,

- *T* une matrice de transformation telle que $(Q_i^{rem}) = T\,(\vec{p}_i^{rem})$, dont la pseudo-inverse est notée *T*\*.

**7.** Procédé selon l'une quelconque des revendications précédentes, **caractérisé en ce que** la détermination de la distribution de sources magnétiques probable fait intervenir une procédure de préconditionnement.

**8.** Procédé selon l'une quelconque des revendications précédentes, **caractérisé en ce que** la détermination de la distribution de sources magnétiques probable fait intervenir une procédure de décomposition en valeurs singulières.

**9.** Procédé de détermination, en temps réel, de la signature magnétique d'un navire, **caractérisé en ce qu'**il comporte une étape de détermination, en temps réel, de l'aimantation de la coque du navire par le procédé selon l'une quelconque des revendications 1 à 8 permettant d'obtenir une distribution de sources magnétiques probable à la surface de la coque, puis une étape supplémentaire consistant à calculer la signature du navire à partir de ladite distribution de sources magnétiques probable.

**10.** Procédé d'immunisation magnétique d'un navire, **caractérisé en ce que**, le navire étant muni d'une pluralité de boucles d'immunisation ayant des géométries déterminées par rapport à la coque du navire et des moyens d'alimentation en puissance électrique aptes à être commandés de manière à faire circuler dans les boucles d'immunisation, indépendamment les unes des autres, des courants adaptés, le procédé comporte, en plus des étapes du procédé de détermination, en temps réel, de la signature du navire selon la revendication 9, une étape consistant à calculer les différents courants à faire circuler dans les boucles d'immunisation de manière à modifier la signature magnétique du navire, et une étape consistant à commander les moyens d'alimentation en puissance électrique de manière à faire circuler, dans les boucles d'immunisation, lesdits courants calculés.

**11.** Dispositif (6) de détermination, en temps réel, de l'aimantation de la coque (1) d'un navire, la coque du navire étant en un matériau ferromagnétique soumis à une excitation magnétique inductrice ($H_0$), **caractérisé en ce qu'**il comporte :

- une pluralité de capteurs de champ magnétique (7) positionnés en des points déterminés par rapport à la coque ;
- des moyens de détermination de l'excitation magnétique inductrice ; et,
- une unité de calcul (13) reliée à la pluralité de capteurs et aux moyens de détermination de l'excitation magnétique inductrice, apte à exécuter les instructions d'un programme d'ordinateur pour la mise en oeuvre d'un procédé de détermination, en temps réel, de l'aimantation de la coque d'un navire selon l'une quelconque des revendications 1 à 8 ou d'un procédé de détermination, en temps réel, de la signature d'un navire selon la revendication 9.

**12.** Dispositif selon la revendication 11, **caractérisé en ce qu'**au moins un capteur de la pluralité (7) de capteurs est collé sur la coque (1).

**13.** Dispositif selon la revendication 11 ou la revendication 12, **caractérisé en ce qu'**au moins un capteur de la pluralité de capteurs (7) est un capteur bi-axes mesurant les composantes du champ magnétiques tangentielles à la coque (1).

**14.** Dispositif selon l'une quelconque des revendications 11 à 13, **caractérisé en ce qu'**au moins un capteur de la pluralité de capteurs (7) est placé à l'extérieur de la coque (1) du navire.

**15.** Dispositif d'immunisation magnétique d'un navire du type comprenant une pluralité de boucles d'immunisation ayant des géométries déterminées par rapport à la coque (1) du navire, des moyens d'alimentation en puissance électrique (10) des boucles d'immunisation, et des moyens de commande des moyens d'alimentation en puissance électrique des boucles d'immunisation, **caractérisé en ce que** les moyens de commande comprennent un dispositif selon l'une quelconque des revendications 11 à 14 apte à calculer, en temps réel, la signature du navire.

**16.** Dispositif selon l'une quelconque des revendications 11 à 15, **caractérisé en ce qu'**il est embarqué à bord du navire dont on détermine l'aimantation de la coque.

## Patentansprüche

**1.** Verfahren zum Ermitteln der Magnetisierung des Rumpfes eines Schiffs in Echtzeit, wobei der Rumpf des Schiffs aus einem ferromagnetischem Material ist und einer induktiven magnetischen Anregung unterworfen ist, und das Schiff mit einer Mehrzahl von Magnetfeldsensoren ausgestattet ist, die bezüglich des Rumpfes an bestimmten Punkten positioniert sind, aufweisend die folgenden Schritte:

a) - Erfassen einer Mehrzahl von Messungen des Magnetfeldes mittels der Mehrzahl von Sensoren,
b) - Bewerten der induktiven magnetischen Anregung, und
c) - Ermitteln einer wahrscheinlichen Verteilung von Magnetquellen an der Oberfläche des Rumpfes durch Lösen eines Gleichungssystems, das sich aus der Modellierung der eingesetzten physikalischen Phänomene ergibt, ausgehend von der Mehrzahl von erfassten Messungen und der bewerteten induktiven magnetischen Anregung,

**dadurch gekennzeichnet, dass** bei der Modellierung die induzierten Magnetquellen durch eine Verteilung von zweipoligen Quellen beschrieben sind und die remanenten Magnetquellen durch eine Verteilung von einpoligen Quellen beschrieben sind, und dass die Modellierung aufweist:

- eine erste Modellierung, die eine Magnetisierungsverteilung im ferromagnetischen Material mit den Messungen des Magnetfelds assoziiert, und
- eine zweite Modellierung bezüglich des Verhaltens des ferromagnetischen Materials, die die Kopplung zwischen einer Magnetquelle an einem Punkt des Materials mit einer Magnetquelle an einem anderen Punkt des Materials beschreibt.

2. Verfahren gemäß Anspruch 1, **dadurch gekennzeichnet, dass** das Verfahren verwendet: eine Transformation $T$, die das Assoziieren mindestens einer Verteilung von einpoligen Quellen mit einer Verteilung von zweipoligen Quellen ermöglicht, und/oder eine Transformation $T^*$, die das Assoziieren mindestens einer Verteilung von zweipoligen Quellen mit einer Verteilung von einpoligen Quellen ermöglicht.

3. Verfahren gemäß Anspruch 2, **dadurch gekennzeichnet, dass** die Modellierung ein virtuelles Modell des Schiffsrumpfes verwendet, das ein primäres Gitternetz aufweist, das aus einer Mehrzahl von ebenen und polygonalen Elementarflächen gebildet ist.

4. Verfahren gemäß Anspruch 3, **dadurch gekennzeichnet, dass** durch die Elementarfläche des primären Gitternetzes die Verteilung von zweipoligen Quellen an diesem Flächenelement gleichförmig und tangential ist.

5. Verfahren gemäß Anspruch 3 oder Anspruch 4, **dadurch gekennzeichnet, dass** die Verteilung einpoliger Quellen an den Knotenpunkten des primären Gitternetzes diskretisiert ist.

6. Verfahren gemäß den Ansprüchen 4 und 5 in Kombination, **dadurch gekennzeichnet, dass** das zu lösende Gleichungssystem wie folgt ist:

$$\begin{pmatrix} A_M & A_M T^* \\ D_M + Id & D_M . T^* \end{pmatrix} \begin{pmatrix} p_i^{ind} \\ Q_i^{rem} \end{pmatrix} = \begin{pmatrix} m \\ S_M \end{pmatrix}$$

wobei:

- $m$ ein Vektor ist, dessen $j^{ste}$ Komponente die Differenz $H(R_j) - H_0(R_j)$ zwischen der Messung der magnetischen Anregung, die am Punkt $R_j$ durch den $j^{sten}$ Magnetfeldsensor durchgeführt wird, und dem Wert der induktiven magnetischen Anregung am Punkt $R_j$ ist,

- $A_M$ eine Matrix ist, deren Element $A_{Mji}$ der Operator $\dfrac{1}{4\pi} \int_{L_i} (u_i . \vec{n}_i) \dfrac{R_i R_j}{R_i R_j{}^3} dL_i(R_i)$ ist, der mit einer Elemen-tarfläche $S_i$ des primären Gitternetzes mit einer Mehrzahl von Kanten $L_i$ assoziiert ist, wobei jede in der Ebene der Elementarfläche $S_i$ eine Normale $\bar{n}$ hat, die zum Äußeren der Elementarfläche hin ausgerichtet ist, und wobei $u_i$ ein Vektordublett ist, das eine Basis der Elementarfläche bildet,

- $S_M$ ein Vektor ist, dessen $i^{te}$ Komponente proportional zu der induktiven magnetischen Anregung $e\chi H_{0i}$ an einem Punkt der $i^{ten}$ Elementarfläche des primären Gitternetzes ist,

- $D_M$ eine Matrix ist, deren Element $D_{Mji}$ der Operator $-\dfrac{\chi e}{4\pi} \int_{L_i} (u_i . \vec{n}_i) \dfrac{R_j R_i}{\left| R_j R_i \right|^3} dL_i(R_i)$ ist, und

- $T$ eine Transformationsmatrix, zum Beispiel $\left( Q_i^{rem} \right) = T \left( \overrightarrow{p_i}^{rem} \right)$ ist, deren Pseudokehrwert mit $T^*$ notiert ist.

7. Verfahren gemäß irgendeinem der vorhergehenden Ansprüche, **dadurch gekennzeichnet, dass** das Ermitteln der wahrscheinlichen Verteilung von Magnetquellen einen Vorgang des Vorkonditionierens beinhaltet.

8. Verfahren gemäß irgendeinem der vorhergehenden Ansprüche, **dadurch gekennzeichnet, dass** das Ermitteln der wahrscheinlichen Verteilung von Magnetquellen einen Vorgang des Zerlegens in Singulärwerte beinhaltet.

9. Verfahren zum Ermitteln der magnetischen Signatur eines Schiffs in Echtzeit, **dadurch gekennzeichnet, dass** es aufweist: einen Schritt des Ermittelns der Magnetisierung des Rumpfes des Schiffs in Echtzeit mittels des Verfahrens gemäß irgendeinem der Ansprüche 1 bis 8, das das Erhalten einer wahrscheinlichen Verteilung von Magnetquellen an der Oberfläche des Rumpfes ermöglicht, und anschließend einen zusätzlichen Schritt, der darin besteht, die Signatur des Schiffs ausgehend von der wahrscheinlichen Verteilung von Magnetquellen zu berechnen.

**10.** Verfahren zur magnetischen Immunisierung eines Schiffs, **dadurch gekennzeichnet, dass** das Schiff mit einer Mehrzahl von Immunisierungsschleifen mit bestimmten Geometrien bezüglich des Rumpfes des Schiffs und mit Mitteln zur Stromversorgung ausgestattet ist, die geeignet sind, derart gesteuert zu werden, dass in den Immunisierungsschleifen unabhängig voneinander angepasste Ströme zirkuliert werden, und das Verfahren zusätzlich zu den Schritten des Verfahrens des Ermittelns der Signatur des Schiffs in Echtzeit gemäß Anspruch 9 aufweist: einen Schritt, der darin besteht, die verschiedenen Ströme zu berechnen, die in den Immunisierungsschleifen zu zirkulieren sind, um die magnetische Signatur des Schiffs zu modifizieren, und einen Schritt, der darin besteht, die Stromversorgungsmittel derart zu steuern, dass die berechneten Ströme in den Immunisierungsschleifen zirkuliert werden.

**11.** Vorrichtung (6) zum Ermitteln der Magnetisierung des Rumpfes (1) eines Schiffs in Echtzeit, wobei der Schiffsrumpf aus einem ferromagnetischen Material ist, das einer induktiven magnetischen Anregung ($H_0$) unterworfen ist, **dadurch gekennzeichnet, dass** sie aufweist:

- eine Mehrzahl von Magnetfeldsensoren (7), die bezüglich des Rumpfes an bestimmten Punkten angeordnet sind,
- Mittel zum Ermitteln der induktiven magnetischen Anregung, und
- eine Recheneinheit (13), die mit der Mehrzahl von Sensoren und mit den Mitteln zum Ermitteln der induktiven magnetischen Anregung verbunden ist, die in der Lage ist, die Befehle eines Computerprogramms zum Durchführen eines Verfahrens zum Ermitteln der Magnetisierung des Rumpfes eines Schiffs in Echtzeit gemäß irgendeinem der Ansprüche 1 bis 8 oder eines Verfahrens zum Ermitteln der Signatur eines Schiffs in Echtzeit gemäß Anspruch 9 durchzuführen.

**12.** Vorrichtung gemäß Anspruch 11, **dadurch gekennzeichnet, dass** mindestens ein Sensor aus der Mehrzahl (7) von Sensoren an den Rumpf (1) geklebt ist.

**13.** Vorrichtung gemäß Anspruch 11 oder Anspruch 12, **dadurch gekennzeichnet, dass** mindestens ein Sensor aus der Mehrzahl von Sensoren (7) ein zweiachsiger Sensor ist, der die Komponenten des Magnetfelds misst, die tangential zu dem Rumpf (1) sind.

**14.** Vorrichtung gemäß irgendeinem der Ansprüche 11 bis 13, **dadurch gekennzeichnet, dass** mindestens ein Sensor aus der Mehrzahl von Sensoren (7) an der Außenseite des Rumpfes (1) des Schiffs angeordnet ist.

**15.** Vorrichtung zur magnetischen Immunisierung eines Schiffs, des Typs, der aufweist: eine Mehrzahl von Immunisierungsschleifen mit bestimmten Geometrien bezüglich des Rumpfes (1) des Schiffs, Mittel zur Stromversorgung (10) der Immunisierungsschleifen und Mittel zum Steuern der Mittel zur Stromversorgung der Immunisierungsschleifen, **dadurch gekennzeichnet, dass** die Steuermittel eine Vorrichtung gemäß irgendeinem der Ansprüche 11 bis 14 aufweisen, die in der Lage ist, die Signatur des Schiffs in Echtzeit zu berechnen.

**16.** Vorrichtung gemäß irgendeinem der Ansprüche 11 bis 15, **dadurch gekennzeichnet, dass** sie an Bord des Schiffs platziert ist, dessen Rumpfmagnetisierung ermittelt wird.

**Claims**

**1.** A method for the real-time determination of the magnetization of the hull of a ship, the hull of the ship being made from a ferromagnetic material and subjected to an inductive magnetic excitation, and the ship being provided with a plurality of magnetic field sensors positioned at predetermined points relative to the hull, comprising the following steps:

a) - acquiring a plurality of measurements of the magnetic field using the plurality of sensors;
b) - assessing the inductive magnetic excitation; and
c) - determining a likely distribution of magnetic sources on the surface of the hull by resolving a system of equations derived from a modelization of the physical phenomena at play, on the basis of the plurality of measurements taken and the assessed inductive magnetic excitation,

**characterized in that**, in said modelization, the induced magnetic sources are described by a distribution of dipolar sources and the remanent magnetic sources are described by a distribution of monopolar sources, and **in that** said modelization comprises:

- a first model associating a magnetization distribution in the ferromagnetic material with the measurements of the magnetic field; and
- a second model, relative to the behavior of the ferromagnetic material, describing the coupling between a magnetic source at one point of the material, with a magnetic source at another point of the material.

2. The method according to claim 1, **characterized in that** the method uses a transform $T$ making it possible to associate at least one distribution of monopolar sources with a distribution of dipolar sources and/or a transform $T^*$ making it possible to associate at least one distribution of dipolar sources with a distribution of monopolar sources

3. The method according to claim 2 **characterized in that** said modelization uses a virtual model of the hull of the ship comprising a primary mesh made up of a plurality of planar and polygonal elementary surfaces.

4. The method according to claim 3, **characterized in that**, by elementary surface of the primary mesh, the distribution of dipolar sources is uniform and tangential to said surface element

5. The method according to claim 3 or claim 4, **characterized in that** the distribution of monopolar sources is discretized at the nodes of the primary mesh.

6. The method according to claims 4 and 5 in combination, **characterized in that** said system of equations to be resolved is written:

$$\begin{pmatrix} A_M & A_M.T^* \\ D_M + Id & D_M.T^* \end{pmatrix} \begin{pmatrix} p_i^{ind} \\ Q_i^{rem} \end{pmatrix} = \begin{pmatrix} m \\ S_M \end{pmatrix}$$

with:

- $m$, a vector whereof the j$^{th}$ component is the difference $H(R_j)$-$H_0$ $(R_j)$ between the measurement of the magnetic excitation done at point $R_j$ by the j$^{th}$ magnetic field sensors and the value of the inductive magnetic excitation at point $R_j$;

- $A_M$, a matrix whereof the element $A_{Mji}$ is the operator $\dfrac{1}{4\pi}\displaystyle\int_{L_i}(u_i.\vec{n}_i)\dfrac{R_iR_j}{R_iR_j^{\,3}}dL_i(R_i)$ associated with an elementary

surface $S_i$ of the primary mesh having a plurality of edges $L_i$, each having a normal $\overline{n}_i$ in the plane of the elementary surface $S_i$ and oriented toward the outside of said elementary surface, and where $u_i$ is a pair of vectors forming a basis of the elementary surface;

- $S_M$, a vector whereof the i$^{th}$ component is proportional to the inductive magnetic excitation $e\chi H_{0i}$ at a point of the i$^{th}$ elementary surface of the primary mesh;

- $D_M$, a matrix whereof the element $D_{Mji}$ is the operator $-\dfrac{\chi e}{4\pi}\displaystyle\int_{L_i}(u_i.\vec{n}_i)\dfrac{R_jR_i}{\left|R_jR_i\right|^3}dL_i(R_i)$ ; and

- $T$, a transformation matrix such that $(Q_i^{rem}) = T\,(\vec{p}_i^{\,rem})$, whose pseudo-inverse is denoted $T^*$.

7. The method according to any one of the preceding claims, **characterized in that** the determination of the likely distribution of magnetic sources involves a preconditioning procedure.

8. The method according to any one of the preceding claims, **characterized in that** the determination of the likely distribution of magnetic sources involves a singular value decomposition procedure.

9. A method for the real-time determination of the magnetic signature of a ship, **characterized in that** it comprises a step for the real-time determination of the magnetization of the hull of the ship using the method according to any one of claims 1 to 8, making it possible to obtain a likely distribution of magnetic sources on the surface of the hull, and then an additional step consisting of calculating the signature of the ship from said likely distribution of magnetic sources.

**10.** A method for the magnetic immunization of a ship, **characterized in that**, the ship being provided with a plurality of immunization loops having predetermined geometries relative to the hull of the ship and power supply means capable of being controlled so as to cause suitable currents to circulate in the immunization loops, independently of one another, the method comprises, in addition to the steps of the method according to claim 9 for the real-time determination of the signature of the ship, a step consisting of estimating the different currents to be circulated in the immunization loops so as to modify the signature of the ship, and a step consisting of controlling the power supply means so as to cause said estimated currents to circulate in the immunization loops.

**11.** A device (6) for the real-time determination of the magnetization of the hull (1) of a ship, the hull of the ship being made from a ferromagnetic material subjected to an inductive magnetic excitation ($H_0$), **characterized in that** it comprises:

- a plurality of magnetic field sensors (7) positioned at predetermined points relative to the hull;
- means for determining the inductive magnetic excitation; and
- a computation unit (13) connected to the plurality of sensors and to the means for determining the inductive magnetic excitation, capable of executing the instructions of a computer program to implement the method according to any one of claims 1 to 8 for the real-time determination of the magnetization of the hull of a ship or the method according to claim 9 for the real-time determination of the signature of a ship.

**12.** The device according to claim 11, **characterized in that** at least one sensor from the plurality (7) of sensors is glued on the hull (1).

**13.** The device according to claim 11 or claim 12, **characterized in that** at least one sensor from the plurality of sensors (7) is a biaxial sensor measuring the components of the magnetic field that are tangential to the hull (1).

**14.** The device according to any one of claims 11 to 13, **characterized in that** at least one sensor from the plurality of sensors (7) is placed outside the hull (1) of the ship.

**15.** A device for the magnetic immunization of a ship of the type including a plurality of immunization loops having predetermined geometries relative to the hull (1) of the ship, power supply means (10) for the immunization loops, and means for controlling the power supply means of the immunization loops, **characterized in that** the control means include a device according to any one of claims 11 to 14 capable of calculating the signature of the ship.

**16.** The device according to any one of claims 11 to 15, **characterized in that** it is onboard the ship whereof the magnetization of the hull is determined.

## FIG.1

**FIG.2**

FIG.3

Comparaison des signatures externes : composante longitudinale

FIG.4

Comparaison des signatures externes : composante verticale

FIG.5

**EP 2 524 236 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2825803